# EUROPEAN PATENT APPLICATION

(11) **EP 2 749 890 A1**
(43) Date of publication of application: **02.07.2014**
(21) Application number: 12199410.7
(22) Date of filing: 27.12.2012
(51) Int. Cl.: G01Q 20/04, G01Q 70/10, G01Q 10/04, B81B 3/00

(54) **A composite beam having an adjustable stiffness.**

(71) Applicant: Nederlandse Organisatie voor Toegepast -Natuurwetenschappelijk Onderzoek TNO, 2628 VK Delft (NL)
(72) Inventor: Sadeghian Marnani, 2628 VK Delft (NL); van Keulen, Alfred, 2628 VK Delft (NL)
(74) Representative: Jansen, Cornelis Marinus

(57) **Abstract**

A composite beam (1) having an adjustable stiffness, for example for use in an AFM, a micromechanical biosensor or acoustic actuator or sensor. The composite beam comprises at least one passive beam (2) and one responsive beam (6) for example a piezoelectric beam. The composite beam further comprises a third beam that may be either a passive beam (10) or a responsive beam, depending on the geometry of the assembly of beams. All three beams are connected at one side with a solid base element (5) and at the other side with a solid distal element (13). The internal mechanical stress induced by the responsive beam will result in a variation of the stiffness of the composite beam. So, the stiffness of the composite beam can be adjusted by stimulating the responsive beam.

The composite beam can also be used in other application where the stiffness of a beam has to be adjusted such as acoustic instruments like microphones or loudspeakers or in for example acceleration sensors.

## Description

The present invention relates to a composite beam having an adjustable stiffness. The composite beam comprising a passive beam and a responsive beam comprising stress inducing means for inducing an internal mechanical stress in the responsive beam.

### State of the art

Composite beams having an adjustable stiffness are used in micromechanical sensors and actuators. Examples of such sensors and actuators are cantilevers holding the sensing tip of an atomic force microscope (AFM) and different types of micro-electro-mechanical systems (MEMS) sensors. An AFM can be used for determining the topography of a surface at atomic dimensions and can even be used for manipulating atoms and molecules on a surface. MEMS sensors, like for example sensors for measuring mass, force and displacement may comprise a cantilever resonator. Beams with an adjustable stiffness allow a better sensitivity, a higher resolution, and a larger dynamic range than conventional beams with a predefined stiffness.

Known are composite beams with an adjustable stiffness composed of a stack of two or more layers, one of the layers being an active layer that can apply a stress on the other layer. The active layer in such a beam can be a piezoelectric layer that expands when a voltage is applied across the piezoelectric layer. Known from Bergamini et al. (A. Bergamini, R. Christen, B. Maag and M. Motavalli, "A sandwich beam with electrostatically tunable bending stiffness", Smart Mater. Struct. 15 (2006), 678-686) is a composite beam comprising a particle filled core layer sandwiched between two outer layers of carbon fibre reinforced plastic. Bergamini et al. describe the use of electrostatic forces to modify the transfer of shear stresses at the interface between the outer layers and the core in order to adjust the stiffness of the composite beam.

Another sandwiched beam with adjustable stiffness is known from US patent 6,336,366 B1. The active layer in this known beam is a piezoelectric layer comprising two electrodes for applying a voltage. Applying such a voltage results in an elongation of the beam and consequently in a change of the stiffness of the beam.

Those who are skilled in the art are familiar with the effect of internal stresses on the elastic stiffness. Reference is made to the scientific article by D.S. Dugdale ("The effect of internal stress on elastic stiffness", J. Mech. Phys. Solids, 1963, Vol. 11, pp.41-47) in which it is described that the stiffness may increase because an additional amount of energy is required to overcome the additional resistance to deformation offered by internal stresses.

### Summary of the invention

An objective of the present invention is to provide a composite beam having an adjustable stiffness, which stiffness can be adjusted in a broad range, while at the same time the elongation or any other deformation of the beam is minimal.

This objective of the invention is obtained by a composite beam having an adjustable stiffness comprising
- a passive beam, and
- a responsive beam comprising stress inducing means for inducing an internal mechanical stress in the responsive beam,
   characterised in that the composite beam further comprises
- a third beam which is either a responsive beam or a passive beam,
- a first rigid interconnection element connected with each of the three beams at a first connection position of each beam,
- a second rigid interconnection element connected with each of the three beams at a second connection position of each beam,
   and further in that
- the three beams are situated in a plane alongside each other, and
- each responsive beam is configured such that the mechanical internal stress is directed along the line between its first connection position and its second connection position.

A responsive beam is a beam that responses to an external stimulus. More in particular a response beam is a beam of which the length can be varied by an external stimulus.

The word beam should not be interpreted as to limit the invention to a piece of material with specific dimensions. The beam may be a rod-like piece of material, which rod may have an elliptical, a circular or a rectangular cross-section. The length of such a rod may be larger than the diameter or width. The beam may also be a piece of material shaped as a plate or foil.

The composite beam comprises at least three interconnected beams of which at least one beam is a responsive beam and at least one beam is a passive beam. The three beams are placed in a plane alongside each other. Each of the three beams is connected with two rigid interconnection elements so that at least a part of each beam extends between the first and second interconnection element. This connection of the three beams and the two interconnection elements provides a rigid assembly of beams. An advantage of such a composite beam is that any deformation, more in particular the elongation or shortening of a responsive beam will be hindered by a passive beam. An effect of such hindering, which may in practice be even a prevention of any length-change of the responsive beam, is that internal stresses will be built op in the beams. As a consequence of these internal stresses, the stiffness of the composite beam will change. The stiffness may either increase or decrease, depending on whether the internal stress is a compressive stress or a tensile stress.

In a preferred embodiment of the composite beam, the three beams are placed such that the assembly of the three beams is symmetric relative to one of the three beams. An advantage of such a symmetric composite beam is that the elongation or shortening of a responsive beam will not result in bending of the composite beam because of symmetry reasons. An effect is that internal stresses may be larger than in case where bending occurs. Another effect is that the composite beam will not show unintended bending.

### Brief description of the figures

- Fig. 1: schematically shows a top view of an AFM composite beam comprising one responsive beam
- Fig. 2: schematically shows a top view of another AFM composite beam
- Fig. 3: schematically shows a side view of the AFM composite beam of figure 1
- Fig. 4: schematically shows a top view of still another AFM composite beam
- Fig. 5: schematically shows a responsive beam comprising two responsive beams
- Fig. 6A: schematically shows symmetrical electrode geometry of a responsive beam
- Fig. 6B: schematically shows comb electrode geometry of a responsive beam
- Fig. 7: schematically shows a layered responsive beam
- Fig. 8: schematically shows a responsive beam comprising a heating wire
- Fig. 9: schematically shows a top view an AFM composite beam comprising a separate distal element
- Fig. 10: schematically shows a resonant composite beam comprising a separate base element
- Fig. 11: schematically shows a resonant composite beam comprising a separate distal element and a separate base element
- Fig. 12: schematically shows a composite beam wherein the responsive beam comprises two parallel responsive beams
- Fig. 13: schematically shows a composite beam wherein the responsive beam is a composite beam
- Fig. 14: schematically shows a resonant composite beam comprising a v-shaped bridging element
- Fig. 15: schematically shows a composite beam comprising non-parallel beams
- Fig. 16: schematically shows another composite beam comprising non-parallel beams

### Detailed description of the invention

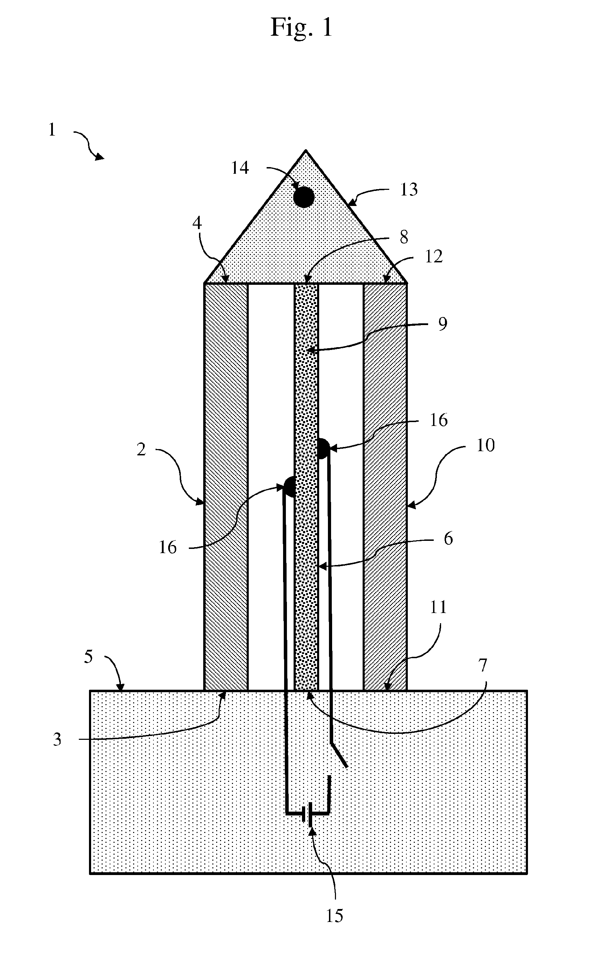

Figure 1 shows schematically a top view of a composite beam for use in an atomic force microscope. The required stiffness constant of a beam or cantilever for atomic force microscopy depends, among others, on the type of AFM and the mode in which the AFM is operated. Typically, the stiffness constant is in the range between 20 and 100 N/m for tapping mode applications, between 1 and 10 N/m for force modulated applications, and 0.05 to 1 N/m for contact mode applications.

The composite beam shown in figure 1 comprises three beams that are situated alongside each other. More in particular, the responsive beam is situated between the two passive beams. The two passive beams (2, 10) and a responsive beam (6) are situated in parallel. However, in other composite beams the passive and responsive beams may incline relative to each other as will be discussed later. The passive beams may be made from or comprise for example silicon (Si), either single crystalline or polycrystalline, borosilicate glass, silicon nitride, silicon oxide, or silicon carbide. Beams or cantilevers for AFM often are coated to tune their properties, in particular their stiffness. Typical coatings are diamondlike carbon and metals such as gold, platinum and aluminium. A metallic coating may also be applied to obtain electrical conductivity or to improve the reflection of the laser light back to a position sensitive detector of the AFM. In practise, such a passive beam of an AFM is between 50 micrometre (µm) and 1 millimetre (mm) long, between 1 micrometre and 100 micrometre wide and has a thickness between 0.1 micrometre and 50 micrometres. Typically, the passive beams of the composite beam have a size that is of the same order of magnitude. The responsive beam, although made out of different material, has for practical reason a similar size. The responsive beam shown in figure 1 can be actuated by an electrical voltage. This embodiment comprises two electrodes (16) configured as to apply a voltage provided by a voltage source (15) to the responsive beam. Typically, the voltage source may be situated not on the beam but in the AFM apparatus.

The responsive beam may comprise a piezoelectric material. Depending on the voltage applied to such a piezoelectric beam, the beam will be elongated or shortened. One side of each of the passive and responsive beams, preferably one of the short sides, is connected at their first connection position (3, 7, 11) with the first interconnection element (5). This side of the beams is also referred to as the base of the beams. In this embodiment the first interconnection element is a solid base element for mounting the AFM tip into the microscope. The interconnection element the beams are connected with, may be made out of the same material as the passive beams or it may be made out of different material. The interconnection element (5) may comprise conductive tracks and electrical connectors for connecting the electrodes to the voltage source. An advantage of making the passive beams and the interconnection element from the same material is that they can be made as one piece out of for example a silicon wafer. When a beam is made out of different material than the interconnection element, such beam and the interconnection element have to be connected with each other by for example gluing, micro-soldering, laser welding, or any other technique suited for connecting small pieces of material.

The other side of the three beams, viz. the side opposite to the side that is connected with the first interconnection element, is connected with a second interconnection element (13) at the respective second connection positions (4,8,12) of the beams. In the embodiment of the composite beam shown in figure 1 this second interconnection element is a solid distal element comprising an AFM tip (14). This side of the beams, viz. the side that is attached to the distal element is also referred to as the distal end of the beams. The second interconnection element may be made out of the same material as the passive beams or out of different material.

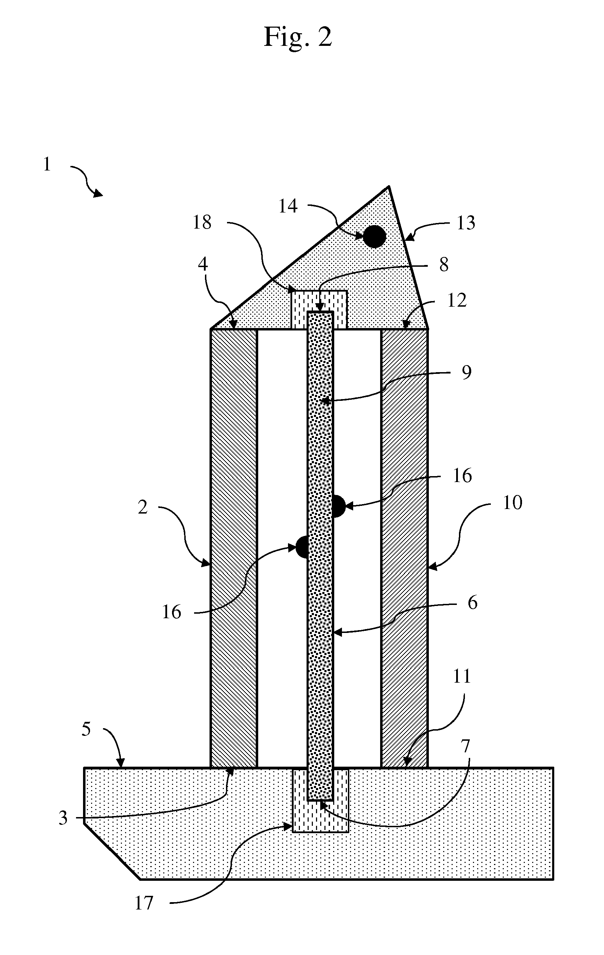

In the embodiment shown in figure 1, all three parallel beams, so the two passive beams and the responsive beam have the same length. However, these beams need not have the same length as is illustrated in figure 2. The two interconnection elements in the embodiment shown in figure 2 have regresses (17, 18) for connection with the responsive beam (6). The regresses may for example comprise glue or the dimensions of the regresses may be adapted to the dimensions of the responsive beam as to clamp the beam without glue. Further, figure 2 illustrates that the first (5) and second (13) interconnection elements need not be symmetric. The geometric form of the interconnection elements may be adapted to specific applications. The solid base element may for example be adapted to fit within a tip holder of an AFM. The solid distal element may for example be adapted for specific AFM techniques, such as torsion AFM.

When the responsive beam is stimulated, for example by applying a voltage to the responsive beam in order to elongate or shorten this beam, the two passive beams will hinder the elongation or shortening of the responsive beam because all beam bases (3,7,11) and all beam distal ends (4,8,12) are connected with each other by solid elements, viz. the two interconnection elements (5, 13). The actual strain of the composite beam will depend on many factors such as the driving force of the responsive beam, which driving force, in case that the responsive beam is a piezoelectric beam, will depend on the applied voltage and the type and orientation of the piezoelectric material. Suitable piezoelectric materials may be ceramic piezoelectric materials, more in particular perovskites such as barium titanate, lead titanate and lead titanate zirconates, zinc oxide, PZT and materials like quartz. Also a polymeric piezoelectric material such as polyvinylidene fluoride (PVDF) may be used.

The actual strain of the composite beam will also depend on the lateral stiffness of the passive beams, so on the type of material the beams are made of and their dimensions. To allow the composite beam to be used as an AFM cantilever, the beam comprises an AFM tip. In the embodiment shown in figure 1, the tip (14) is situated at the top of the triangular solid distal end (13) and extends in the direction perpendicular to the plane of the drawing. In other embodiments the distal element may be for example rectangular and the tip may be placed out of the centre. This may be the case in a tip for torsion AFM. The tip may be made of for example silicon, carbon, or glass. Typically, an AFM tip is made of the same material as the distal element, although it may be coated, for example by diamond or carbon, to make the tip more wear resistant. However, different tips may be connected with the solid distal element.

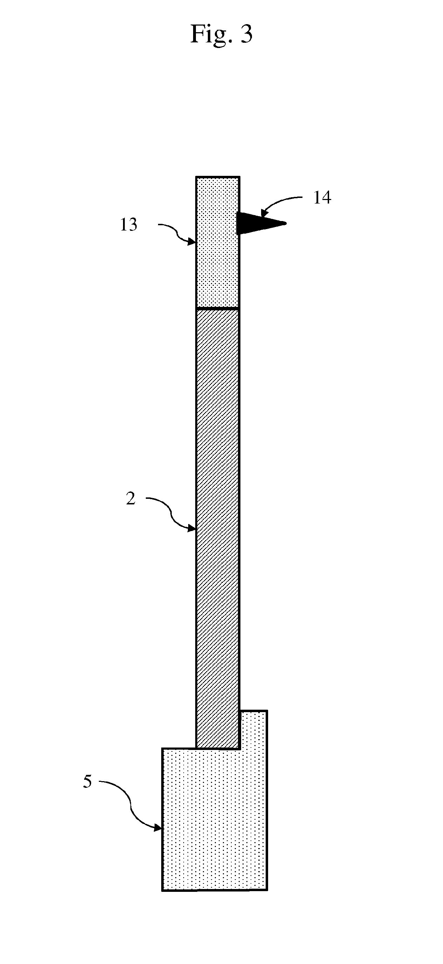

In figure 3, a side view of a composite AFM beam is shown. The tip (14) is fixed to the second interconnection element (13), which interconnection element is a solid distal element in this embodiment. In this embodiment, the second interconnection element has the same thickness as the passive beam (2). However, in other embodiments the second interconnection element may be thicker or thinner than the passive beam or passive beams. The second interconnection element may be made out of the same material as the passive beams or out of different material. The beams and the second interconnection element may be connected by for example gluing. Preferably however, the second interconnection element and the passive beams are made out of one piece of material, for example a silicon wafer. The passive beam is connected with the first interconnection element (5), in this embodiment a solid base element, for example by gluing, micro soldering, or laser welding. The first interconnection element may be made out of the same material as the passive beam. In practise the first interconnection element, or a major part of the first interconnection element, as shown in figure 3, may be thicker than the passive beams. A thick interconnection element gives a certain mechanical robustness to the composite beam. The interconnection elements and the passive beams may be made from one piece of material.

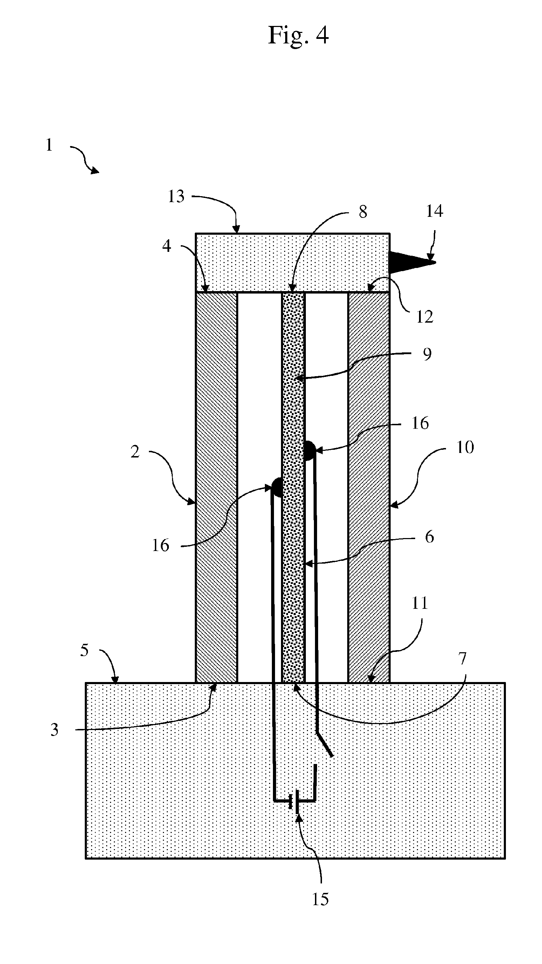

Figure 4 shows still another embodiment of a composite AFM beam. This composite beam is similar to the beam of figure 1 and has two passive beams and one responsive beam. Each of the passive beams is connected at one side with a first interconnection element at its first connection position (3,11) and connected at another side with the second interconnection element at its second connection position (4,12). Here, the first interconnection element is a solid base element and the second interconnection element is a solid distal element. In this embodiment the responsive beam (6) is placed between the two passive beams, the responsive beam being attached to the first connection element at its first connection position (7) and to the second interconnection element at its second connection position (8). The difference between this embodiment and the composite beam of figure 1 is the position of the tip. In the embodiment shown in figure 4, the tip (14) extends in the plane of the drawing. In other words, the two passive beams and the responsive beam in this embodiment are arranged above the other when looking in the direction of the AFM tip (14), viz. in the direction from the composite beam to a sample under test.

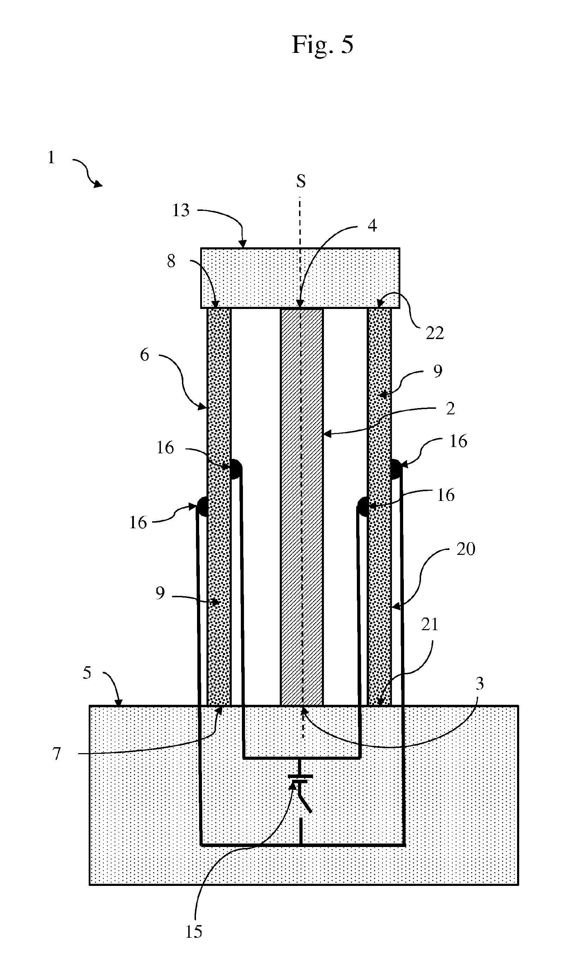

The responsive beams shown in the figures 1, 2 and 4 have one responsive beam and two passive beams. Another embodiment of the composite beam, as shown in figure 5, has two responsive beams and one passive beam. Here, the passive beam (2) is placed between two responsive beams (6,20). The passive beam is connected with the first interconnection element at a first connection position (3) and with the second interconnection element at a second connection position (4). The two bases of the responsive beams are connected at a first connection position (7,21) with the first interconnection element (5), here the solid base element. The distal ends of the responsive beams are connected with the second interconnection element, here a distal element, at a second connection position (8,22). This assembly of three beams is preferably symmetric relative to the passive beam as indicated by the dashed line (S). This may be a point symmetry or a mirror symmetry. In order to avoid unwanted bending of the composite beam in the plane of the drawing, the responsive beams are preferably identical.

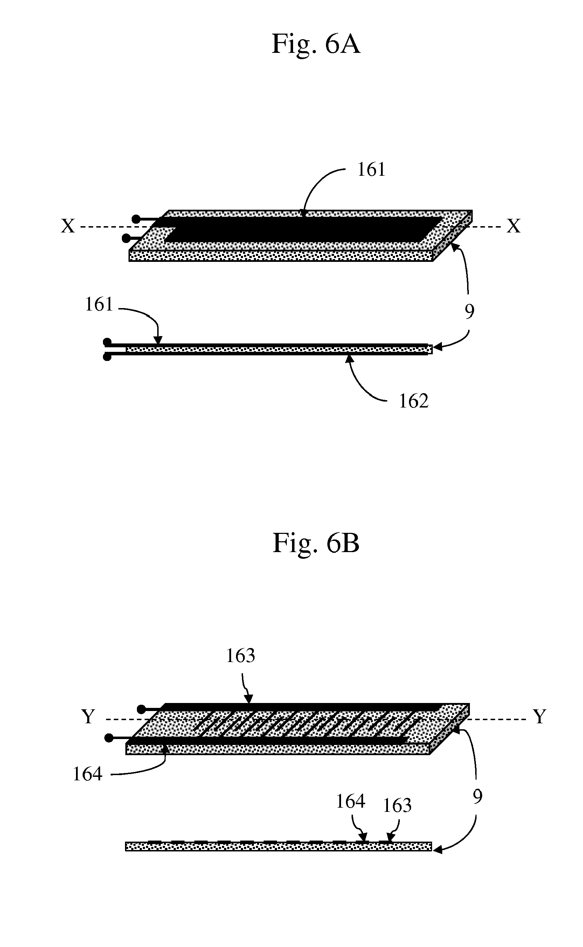

The responsive beams (6,20) may be made of any type of material that expands or shrinks when subjected to a certain stimulus. Such a material may for example be a piezoelectric material and stimulated by an electrical voltage. When the responsive beam is made out of a piezoelectric material then the beam may comprise electrodes on opposite sides of the beam as shown in figure 6A or for example comb electrodes at one side as shown in figure 6B. In the embodiment of figure 6A the two electrodes (161,162), which may for example be a thin metallic coating, are on the bottom and top side of the beam as can be seen in the lower drawing that is a cross section along the dashed line (XX) in the upper drawing. In this preferred geometry the electric field is across the thinnest part of the beam. However, the electrodes may also be deposited onto the two opposite sides of the responsive beam, in this embodiment the sides that are facing the passive beams.

Electrodes for providing an electric field in a thin layer may also be of a comb structure as shown in figure 6B. Such an electrode structure in which the electrodes (163, 164) are on one side of the responsive beam (9), as can be seen in the lower drawing that is a cross section along the dashed line (YY) in the upper drawing, is in particular suitable in cases where one of the sides of the responsive layer must be free, for example to absorb gas or liquid for sensing purposes. When using this type of electrode geometry in an AFM cantilever or other type of composite beam, one should take into account that such a beam is non-symmetric with respect to the plane of the beams, distal element and base element. Such non-symmetry may introduce a complex stress pattern in the responsive beam.

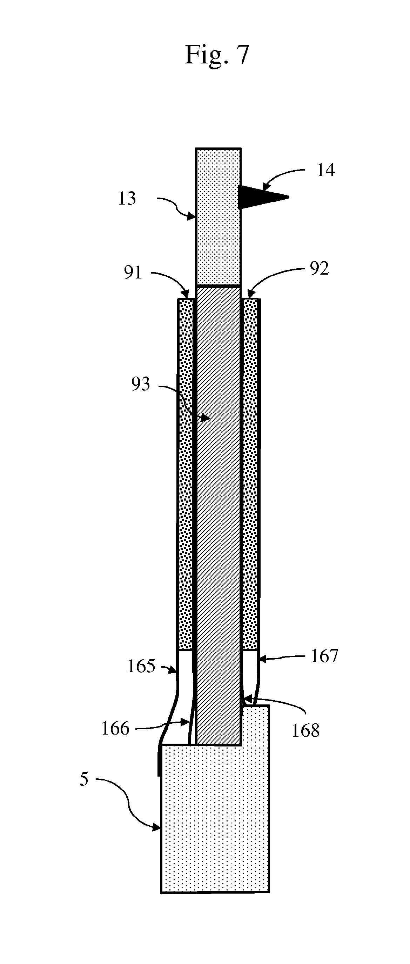

The responsive beam may itself be a beam that is composed of several layers. An example of such an embodiment of the responsive beam is shown in figure 7. Figure 7 is a cross section of a responsive beam, the first interconnection element (5) which is a solid base element in this embodiment, and the second interconnection element (13), here a solid distal element comprising a tip (14). The embodiment of the responsive beam shown in figure 7 comprises a passive layer (93) sandwiched between two responsive layers (91, 92). The layers may be stacked in the direction of the tip as shown in figure 7 or the layers may be stacked in the direction perpendicular to the plane of drawing. The passive layer may be of the same material as the two passive beams, for example silicon. Preferably, the passive layer (93), the two passive beams and the distal solid element are made out of one piece of material by for example micromachining. More preferably, in addition the base also is made out of the same piece of material. In the embodiment shown in figure 7, the two responsive layers (91, 92) are actuated by an electrical voltage. The responsive layers may be a piezoelectric layer, like for example a thin ceramic piezoelectric layer such or a polymeric piezoelectric film, such as PVDF. The piezoelectric layers are attached to the passive layer in order to induce a stress in the passive layer. Preferably, the two piezoelectric layers are identical for symmetry reasons. The electrodes (165,166, 167, and 168) of both responsive layers are configured in such a way that the electric field in both layers is either directed towards the passive layer or directed away from the passive layer. Therefore, the electrodes (165) and (167) may be electrically connected to each other, just as the electrodes (166) and (168).

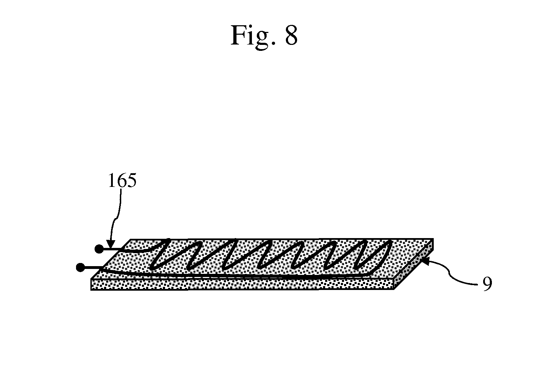

The responsive beam of a composite beam can be made out of or comprising any suitable responsive material. As mentioned above, such a responsive material may be a piezoelectric material. However, a responsive beam may also comprise or made of temperature sensitive material, viz. material that expands or shrinks when heated or cooled. Preferred are temperature sensitive materials having a large positive or negative thermal expansion coefficient. The responsive beam (9) may be heated by a resistive heating wire or by heating electrodes (165) as shown in figure 8. In an embodiment of the composite beam wherein the responsive beam is heated, such a beam is preferably thermally isolated from the solid elements. Such thermal isolation may for example be obtained by applying polymeric glue with a low thermal conductivity for connection of the beam on the interconnection elements.

The actuation or stimulation of the responsive beam need not be of electrical origin. Alternatively, the responsive beam may response on a chemical or biological stimulus. The responsive beam may for example comprise a material that can adsorb or absorb molecules selectively for use in for example micromechanical biosensors or chemical or biochemical sensors.

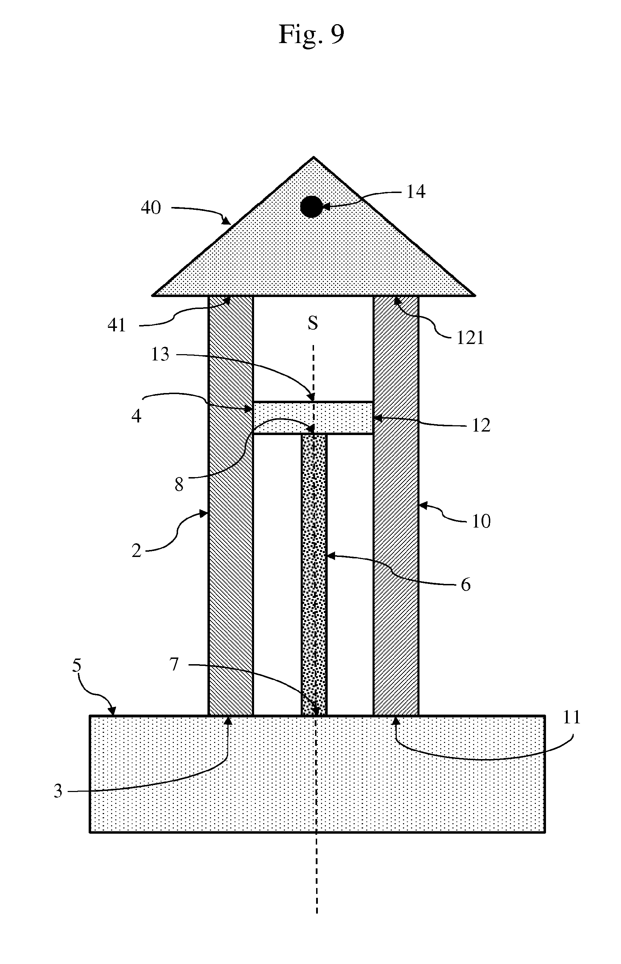

Figure 9 shows a composite AFM beam comprising a separate solid distal element (40). This embodiment of the composite beam has three beams; two passive beams (2,10) and one responsive beam (6). The responsive beam is placed in between the two passive beams, preferably in the middle in order to provide an assembly of beams that is symmetric relative to this responsive beam, as indicated by the dashed line (S). The beams are connected with the first interconnection element, here a solid base element, at the first connection positions (3,7,11). Further, the three beams are connected with the second interconnection element (13) at their second connection positions (4,8,12). However, in this embodiment, the second interconnection element is not a solid distal element. This embodiment comprises a separate distal element (40), the distal element comprising a tip (14). The two passive beams are longer than the responsive beam and therefore extending from their bases beyond the second interconnection element (13) to their distal ends (41,121), which distal ends are attached to the solid distal element.

When the responsive beam tries to elongate or shorten as a result of a stimulus that is applied to the responsive beam, this beam will exert a force on the passive beams in the direction away from the first interconnection element, viz. the base, towards the second interconnection element. More in particular the internal stress in the part of the passive beams between the passive beam bases (3,11) and the second connection positions (4,12) will change. In this embodiment a part of each of the passive beams, viz. the parts between the second connection positions (4,12) and the end of the passive beams (41,121), will be stress free in case there is no internal pre-stress in absence of the stimulus. An advantage of this embodiment is that more effect on the stiffness can be achieved because the actuation is close to the base.

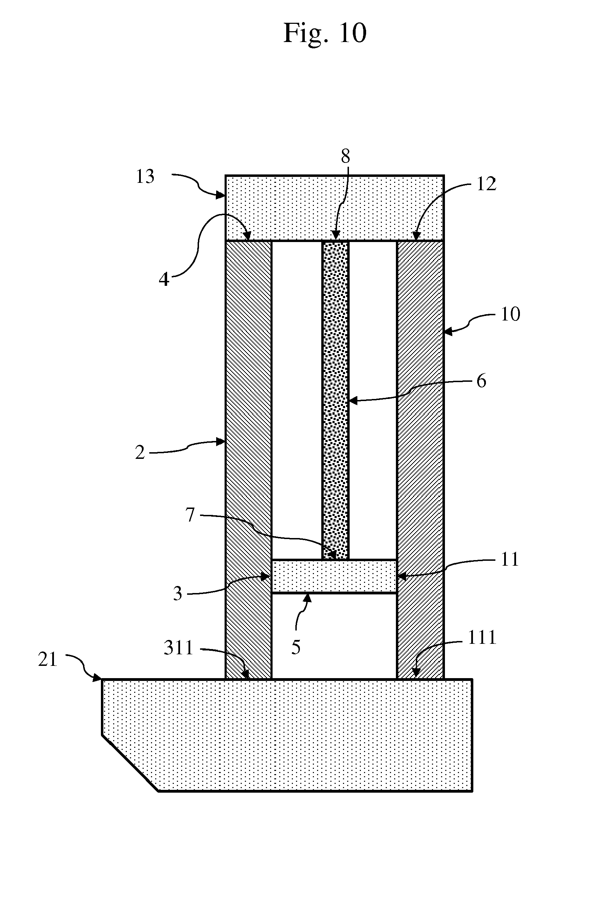

Figure 10 also shows an embodiment of a composite beam where the responsive beam (6) is shorter than the two passive beams (2,10). The difference between this embodiment and the one shown in figure 9 is that this composite beam has a separate solid base element (21), whereas the second interconnection element (13) is a solid distal element. The distal ends of the three beams, viz. the end of the responsive beam situated between two parallel passive beams and the distal end of the passive beams, are connected at the second connection position (4,8,12) with the second interconnection element. The first interconnection element (5) is connected with the responsive beam at the first connection position (7) of the responsive beam and with the passive beams at their first connection positions (3,11). The distal element (13) may comprise an AFM tip (not shown), but the distal element may also be a mass without tip. The embodiment of the composite beam comprising a mass may be applied in an acceleration sensor. The two passive beams, which are longer than the responsive beam, extend beyond the first interconnection element and are attached to the solid base element at their respective bases (311,111). Consequently, the part of the two passive beams between the connection positions (3,11) and the bases of the beams (311,111) will be free of stress. An advantage of this embodiment is that it allows further miniaturization because in this embodiment the active part is close to the distal element.

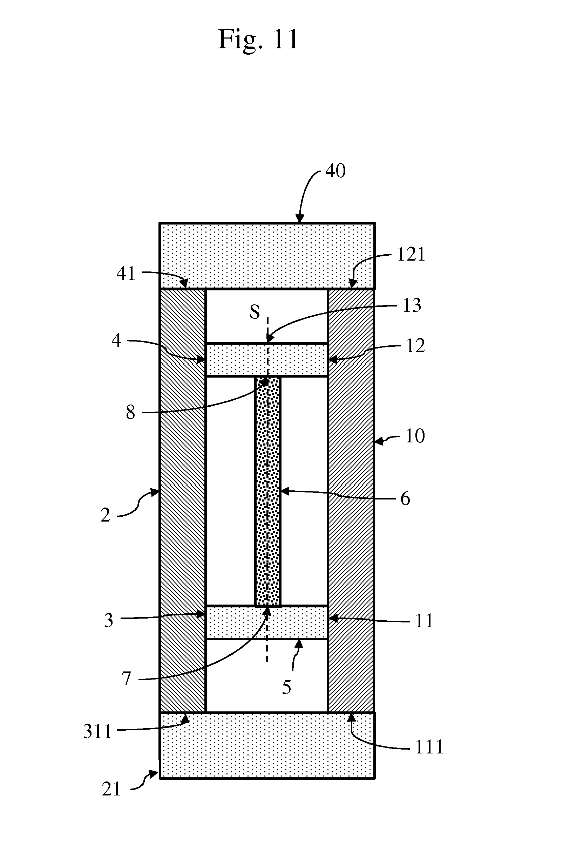

Figure 11 shows a composite beam comprising a separate solid distal end (40) and a separate solid base element (21). This embodiment also has three beams, two passive beams (2,10) and a responsive beam (6) in parallel to each other, whereas the responsive beam is situated between the two passive beams. Preferably, the assembly of these beams and the two interconnection elements is symmetric relative to the responsive beam as indicated by the dashed line (S). The bases (311,111) of the two passive beams are connected with the solid base element (21) and the distal ends (41,121) of these beams are connected with the solid distal element (40). The first interconnection element (5) is connected with the two passive beams at their first connection positions (3,11) and with the responsive beam at its first connection position (7). The second interconnection element (13) is connected with the two passive beams at their second connection positions (4,12) and with the responsive beam at its second connection position (8). The first connection positions of the beams are closer to the solid base element than to the solid distal element, whereas the second connection positions of the beams are closer to the solid distal element than to the solid base element.

When a stimulus is applied to the responsive beam, internal stress will build up in the two passive beams only in the parts between the first connection positions (3,11) and the second connection positions (4,12), viz. the part of the passive beams between which the responsive beam is connected with these passive beams via the interconnection elements. There is no stress in the passive beams between each of the connection positions and the closest solid element, viz. between the first connection positions (3,11) and the solid base element and between the second connection position (4,12) and the solid distal element. An advantage of this embodiment is that the mass and the stiffness of the composite beam can be decoupled. Such an embodiment may also be preferred in applications where both solid distal element and the solid base element are mechanically fixed to a structure to prevent any movement. Embodiments with a fixed distal element and a fixed base element can for example be used in acoustic applications where the composite beam is actuated to vibrate.

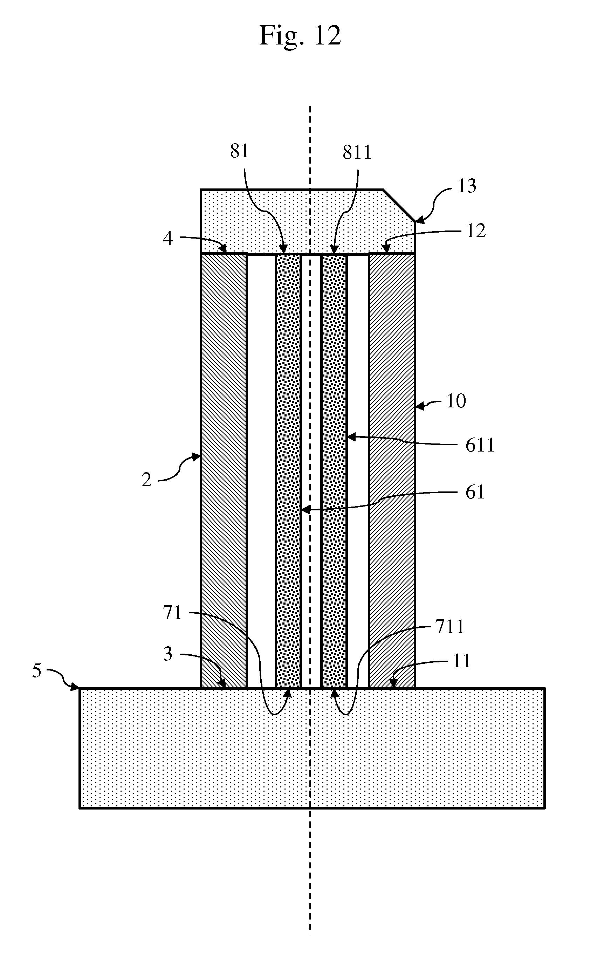

Figure 12 shows a composite beam comprising two identical passive beams (2,10) and a responsive beam that is construed out of two parallel responsive beams (61,611) that are connected with the solid base element (5) at their first connection positions (71,711) and on the solid distal element (13) at their second connection positions (81,811). The two responsive beams are situated between two passive beams (2,10), which passive beams are connected with the solid base element (5) at their first connection positions (3,11) and with the solid distal element (13) at their second connection positions (4,12). The preferred symmetry of this beam assembly is indicated by a dashed line (S), which line lies in the middle of the two-leg responsive beam. Such a symmetric assembly is preferred because it avoids bending of the composite due to internal stresses. In particular it avoids unwanted bending of the composite beam in the plane of the drawing. The solid distal element and the solid base element, however, need not be symmetric to avoid such bending. Such an embodiment comprising a double responsive beam may be advantageous if a single responsive beam does not provide the required stress.

The composite beam according to the invention is not limited to embodiments made out of three separate beams, viz. two passive beams and one responsive beam or two responsive beams and one passive beam. The composite beam may be made of an even or an odd number of beams. For many applications however, a symmetric beam assembly is preferred as discussed before. Such a symmetric assembly can be obtained by an odd number of beams, but also with an even number as indicated for example in figure 12.

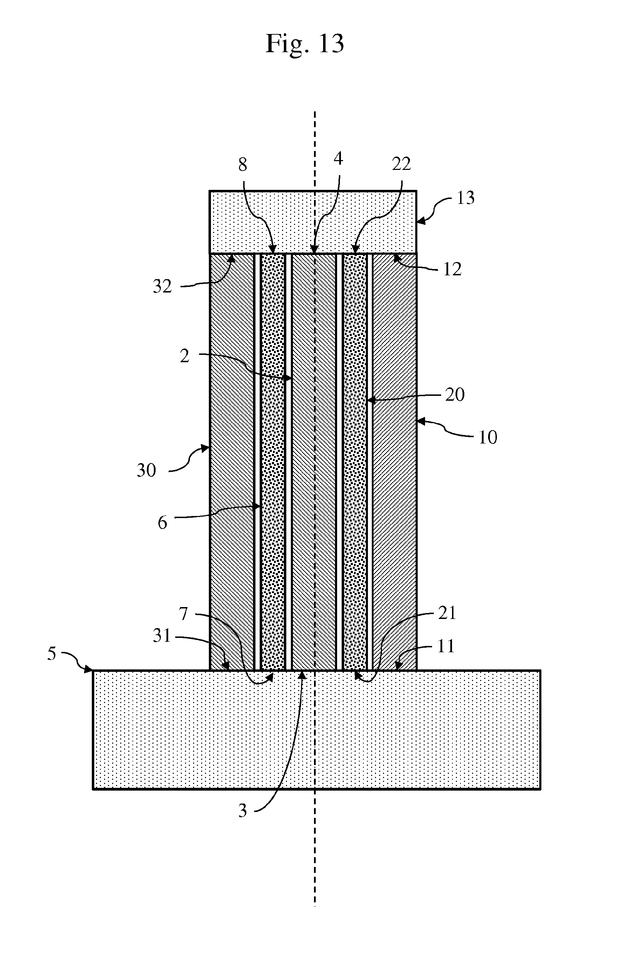

Figure 13 shows an embodiment of the composite beam having five beams, two responsive beams (6,20) and three passive beams (2, 10, 30). The two different types of beams, viz. the responsive beams and the passive beams are placed parallel to each other alternately with a responsive beam in the middle. This assembly of beams (30,6,2,20,10) is symmetric relative to the middle passive beam (2) to avoid unwanted bending of the composite beam from internal stresses. Actually this composite beam is a composite beam comprising a second composite beam having two responsive beams (6,20) and one passive beam (2), itself. The second composite beam is situated between two passive beams (10,30). Such an embodiment comprising multiple passive and responsive beams may be preferred for better force distribution.

Many variations of the embodiment shown in figure 13 are possible. Not only different solid distal elements and different solid base elements can be applied, but also different assemblies of beams. One may for example change each responsive beam of figure 13 into a passive beam and each passive beam into a responsive beam. One may also replace the inner composite beam, viz. the two responsive beams and the passive beam by assemblies similar to the ones shown in figures 9, 10, and 11. Further, one may extend the number of parallel beams, preferably keeping the symmetry.

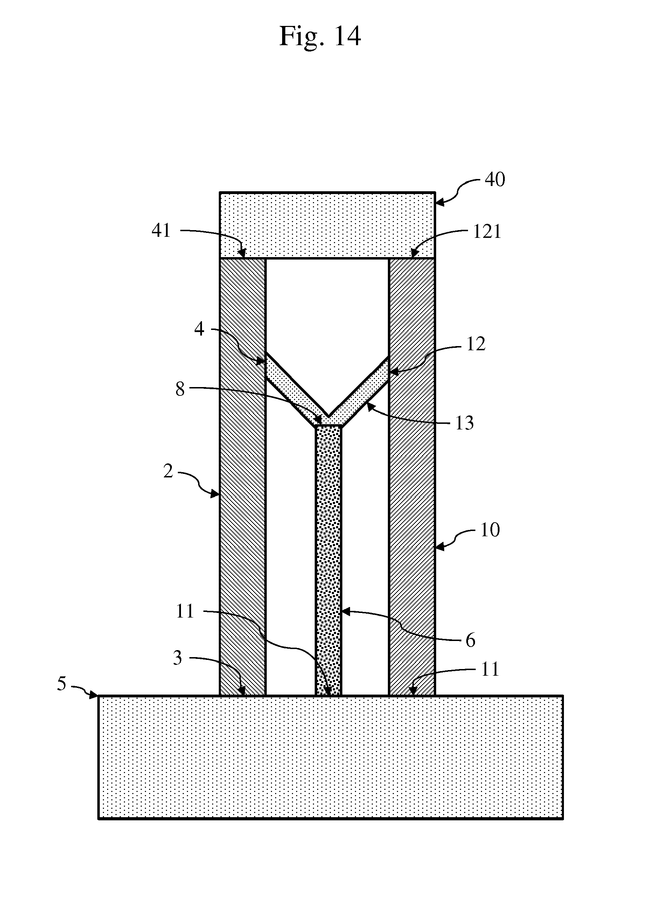

Figure 14 shows a composite beam comprising a second interconnection element (13) having a V-shape. This composite beam has three beams, two passive beams (2,10) and a responsive beam (6). This embodiment of the composite beam has a separate distal element (40) in addition to the first interconnection element, being a solid base element in this embodiment, and the second interconnection element. A difference between the composite beam shown in figure 14 and the one of figure 9, is that the second interconnection element has a V-shape. The two passive beams are connected with the solid base element at their first connection positions (3,11) and with the V-shaped second interconnection element at their second connection positions (4,12). The stress in the responsive beam is guided via the legs of the V-shaped interconnection element to the passive beams, resulting in a stress in the part of the passive beams between their first connection positions (3,11) and their second connection positions (4,12). The part of the beams between their second connection positions (4,12) and their distal end (41,121) remains stress free. An advantage of this embodiment is that it gives additional freedom in the design.

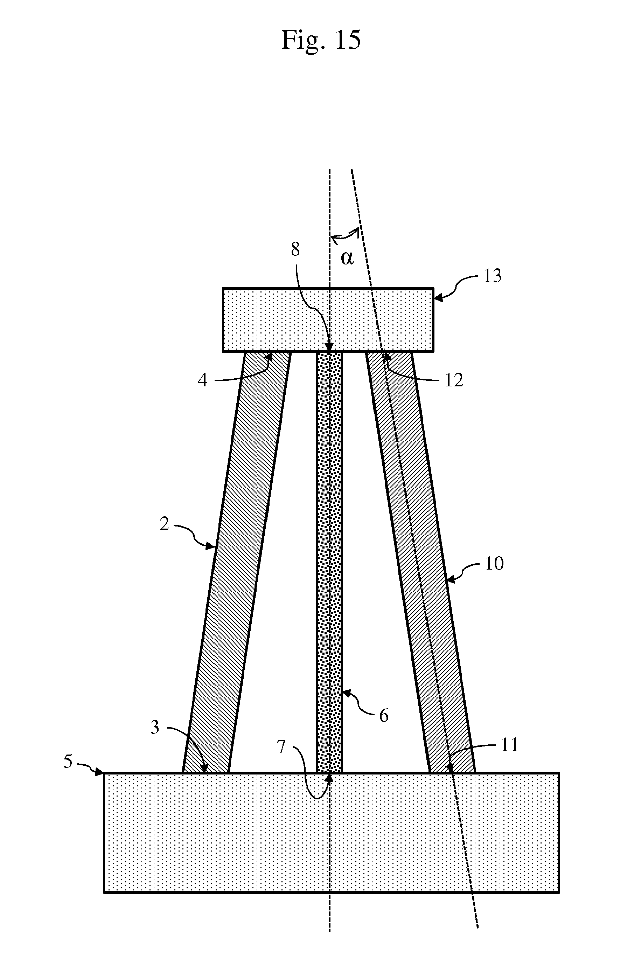

In the embodiment shown in figure 15 the three beams of the composite beam are not parallel, although they are all situated in the same plane, viz. the plane of the drawing. The responsive beam is situated between the two passive beams. The two passive beams (2,10) are inclined relative to the responsive beam (6) at an angle (α), which geometry may be preferred to guide the stresses between the solid base element (5) and the solid distal element (13). Preferably the angle is smaller than 45 degrees. more preferably smaller than 33 degrees. The inclination of the beams may be in the direction of the distal element as shown in figure 15. It may also be in the opposite direction, viz. in the direction of the base element (5). This three-leg wedge-shaped configuration can replace parallel beam configurations as shown in for example the figures 1, 2, and 4. Preferably the assembly of beams is symmetric relative to the responsive beam as indicated by the dashed line (S). In a proper symmetry of the beam assembly, for example a mirror symmetry or a point symmetry, the internal stress in the responsive beam will not result in an asymmetric stress distribution because the internal stresses in both passive beams will be identical.

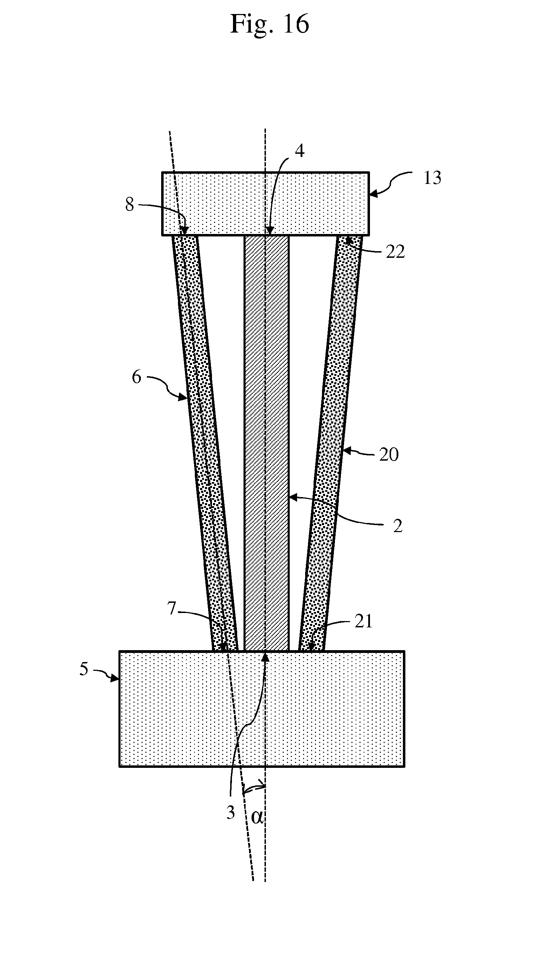

In the three-leg configuration of a composite beam shown in figure 16, two responsive beams (6,20) which are placed along a passive beam (2) incline to each other with the passive beam in between. The three beams are connected with the solid distal element at their distal ends (8,4,22) and with the solid base element (5) at their bases (7,3,21). This results in a wedge-shaped configuration. Such an embodiment may be preferred when the solid distal end has large lateral dimensions.

Preferably, the passive beams are stress-free in absence of the stimulus. However, the composite beam may be structured so that there is a pre-stress in the composite beam. In such embodiments of the composite beam, stimulating the responsive beam will reduce the internal stress and consequently change the stiffness of the composite beam.

It is understood that an element of one embodiment can be applied in another embodiment. The composite responsive beam shown in figure 7 and the thermal beam shown in figure 8 can for example be applied in the AFM beam of figure 2. More in particular, the composite beam may comprise a different distal element than the one shown and described in a specific embodiment. For example in the embodiments comprising an AFM tip, such tip may be omitted or replaced by for example a mass. Further, in embodiments with parallel beams, the beams may incline as shown for example in figure 15.

Composite beams may be made partly out of for example a wafer, more in particular a silicon wafer. This allows making many semi-finished beams in one wafer, and keeping such beams attached to the wafer, for example by a small bridge from the wafer to the solid base element. A composite beam may be finished when it is still attached to the wafer, for example by addition of a responsive beam or it may be finished later. Composite beams or semi-finished composite beams, which may be very fragile pieces of material can be transported more safely when they are attached to the wafer.

## Claims

1. A composite beam (1) having an adjustable stiffness comprising
- a passive beam (2), and
- a responsive beam (6) comprising stress inducing means (9) for inducing an internal mechanical stress in the responsive beam,
**characterised in that**
the composite beam further comprises
- a third beam which is either a responsive beam or a passive beam (10),
- a first rigid interconnection element (5) connected with each of the three beams at a first connection position of each beam (3,7,11),
- a second rigid interconnection element (13) connected with each of the three beams at a second connection position of each beam (4,8,12),
and further **in that**
- the three beams are situated in a plane alongside each other, and
- each responsive beam is configured such that the mechanical internal stress is directed along the line between its first connection position (7) and its second connection position (8).

2. A composite beam according to claim 1, wherein the assembly of the three beams (2,6,10) is symmetric relative to one of the three beams.

3. A composite beam according to claim 1 or 2, wherein said beams (2,6,10) are parallel.

4. A composite beam according to any of the preceding claims, wherein each responsive beam comprises piezoelectric material.

5. A composite beam according to any of the preceding claims, wherein the responsive beam comprises a passive layer (93) and a responsive layer (91).

6. A composite beam according to any of the preceding claims wherein the responsive beam comprises a temperature sensitive material and heating means (165) for heating the temperature sensitive material.

7. A composite beam according to any of the preceding claims wherein the responsive beam is shorter than each of the passive beams.

8. A composite beam according to any of the preceding claims, wherein the second interconnection element is mainly made of the same material as the passive beam.

9. A composite beam according to any of the preceding claims, wherein the first interconnection element is mainly made of the same material as the passive beam.

10. A composite beam according to any of the preceding claims, wherein the passive beams and both interconnection elements are made out of a single piece of material.

11. A composite beam according to any of the preceding claims, wherein the passive beam comprises mainly silicon.

12. A composite beam according to any of the preceding claims, comprising an AFM tip that is directed out of the plane of the three beams.

13. A wafer comprising at least one composite beam according to claim 10.

14. A sensor comprising a composite beam according to any of the claims 1 to 11.

15. An actuator comprising a composite beam according to any of the claims 1 to 11.
